# EUROPÄISCHE PATENTSCHRIFT

(11) **EP 2 736 312 B1**
(45) Veröffentlichungstag und Bekanntmachung des Hinweises auf die Patenterteilung: **16.08.2017**
(21) Anmeldenummer: 12194363.3
(22) Anmeldetag: 27.11.2012
(51) Int. Cl.: H05K 7/14, H05K 7/20

(54) **Automatisierungsgerät mit Kühlkörper**
Automation device with cooling element
Appareil d'automatisation avec corps de refroidissement

(43) Veröffentlichungstag der Anmeldung: 28.05.2014
(73) Patentinhaber: Siemens Aktiengesellschaft, 80333 München (DE)
(72) Erfinder: Bäuml, Mathias, 92421 Schwandorf (DE); Michl, Julia, 93133 Burglengenfeld (DE); Schmelz, Jürgen, 90610 Winkelhaid (DE)

(56) Entgegenhaltungen:
- EP-A1- 1 793 289
- EP-A1- 2 187 716
- EP-A2- 0 845 930
- EP-A2- 2 073 616
- DE-A1- 10 316 967
- US-B1- 6 324 057

## Beschreibung

Die Erfindung betrifft ein Automatisierungsgerät ausgestaltet für den Einsatz in einem Automatisierungsumfeld zur Automatisierung eines industriellen Prozesses, aufweisend eine erste Leiterplatte, eine zweite Leiterplatte, ein erstes zu kühlendes elektronisches Bauteil und ein zweites zu kühlendes elektrisches Bauteil, das erste zu kühlende elektronische Bauteil ist auf der ersten Leiterplatte und das zweite zu kühlende elektronische Bauteil ist auf der zweiten Leiterplatte angeordnet, wobei ein Kühlkörper auf der ersten Leiterplatte und das erste elektronische Bauteil zwischen der ersten Leiterplatte und dem Kühlkörper angeordnet ist, der Kühlkörper ist dabei quaderförmig ausgestaltet und liegt mit einer in einer ersten Seitenfläche des Kühlkörpers eingearbeiteten ersten Kühlkontaktfläche auf dem ersten elektronischen Bauteil auf.

Die Patentschrift US 6,324,057 B1 zeigt eine speicherprogrammierbare Steuerung mit einer schwimmend gelagerten Aufhängung für Leiterplatten.

Die EP 0 845 930 B1 zeigt ein Automatisierungsgerät mit einem Gehäuse, bei welchen ein Kabelanschlussraum optimiert wurde, um das Gehäuse kompakter zu gestalten.

Die europäische Offenlegungsschrift EP 2 073 616 A2 offenbart eine Geräteeinheit für eine CNC-Maschine, bei welcher eine Entwärmung der Geräteeinheit mittels zweier Radiallüfter realisiert ist.

Aufgrund einer Miniaturisierung von Elektronikkomponenten, wird zunehmend eine höhere Packungsdichte/Funktionsdichte an elektronischen Komponenten/Bauteilen auf einer Flachbaugruppe, wie beispielsweise einer bestückten Leiterplatte, realisiert. Dies führt zu einer Erhöhung der Verlustleistung, insbesondere bei Mikroprozessoren, da die Leistungsfähigkeit von Mikroprozessoren zunehmend steigt und damit auch die Verlustwärme steigt.

Üblicherweise werden an einen Kühlkörper ein oder mehrere elektronische Bauteile, welche sich auf einer Leiterplatte befinden, thermisch angebunden. Auch ist bekannt, wenn es in einem elektronischen Gerät mehrere Leiterplatten gibt, diesen mehreren Leiterplatten jeweils einen separaten Kühlkörper zuzuordnen. Es kann somit in einem elektronischen Gerät mehrere Kühlkörper geben, welche in Summe nicht voll ausgenutzt werden können. Dies führt dazu, dass die Leistungsdichte geringer ausfallen muss, als diese theoretisch sein könnte.

Die Rechenleistung eines Automatisierungsgerätes führt zu einer Verlustleistung. Je höher die Rechenleistung, desto höher die Verlustleistung (Wärme). Die verwendeten Prozessoren werden immer leistungsfähiger, die Verlustleistung steigt somit. Gleichzeitig sollen die Außenabmaße des Automatisierungsgerätes immer kleiner werden. Dadurch muss immer mehr Wärme aus immer kleineren Gehäusen abgeführt werden.

Somit ist die Leistungsdichte letztendlich (Verlust-)leistung pro Volumeneinheit, z.B. Watt pro dm^{^}3.

Aufgrund dessen müssen immer größere technische Anstrengungen unternommen werden um die zulässigen Temperaturen einzuhalten.

Aufgabe der Erfindung ist es die Leistungsdichte eines Automatisierungsgerätes zu erhöhen.

Die Aufgabe wird für das eingangs genannte Automatisierungsgerät dadurch gelöst, dass die zweite Leiterplatte im Wesentlichen senkrecht zu der ersten Leiterplatte angeordnet, wobei eine in einer zweiten Seitenfläche des Kühlkörpers eingearbeitete zweite Kühlkontaktfläche auf dem zweiten elektronischen Bauteil aufliegt. Demnach können an einem Kühlkörper zwei Leiterplatten mit ihren jeweiligen elektronischen Bauteilen thermisch angebunden werden. Hierfür wird beispielsweise an dem Kühlkörper eine zweite Kühlbasis im rechten Winkel zur ersten Kühlbasis zur Wärmeeinkopplung angebracht. Dabei wird der zur Verfügung stehende Bauraum optimal ausgenutzt. Die Leistungsfähigkeit des Kühlkörpers kann somit in bestmöglicher Weise ausgenutzt werden. Der Wirkungsgrad des Gesamtsystems wird größer, da die maximal mögliche Verlustleistung bezogen auf den Bauraum steigt.

In einer vorteilhaften Ausgestaltung ist die zweite Leiterplatte an der zweiten Seitenfläche des Kühlkörpers befestigt. Insbesondere bei Automatisierungskomponenten können bei einem Einsatz in einem industriellen Umfeld Vibrationen auf das Automatisierungsgerät wirken, wenn die zweite Leiterplatte mit der zweiten Seitenfläche des quaderförmigen Kühlkörpers verbunden ist, sinkt die Wahrscheinlichkeit einer mechanischen Beanspruchung der zweiten Leiterplatte.

In einer weiter optimierten Ausgestaltung des Automatisierungsgeräts weist dieses ein Grundgehäuse auf, wobei der Kühlkörper mit seiner ersten Seitenfläche mittels eines Festlagers mit dem Grundgehäuse verbunden ist, wobei zwischen einer Innenseite einer Unterseite des Grundgehäuses und der ersten Seitenfläche des Kühlkörpers die erste Leiterplatte angeordnet ist, weiterhin ist eine Außenseite der Unterseite des Grundgehäuses mit Befestigungsmitteln für eine Montage an einer vertikalen Komponente ausgestaltet, wobei im montierten Zustand des Grundgehäuses die Unterseite parallel zu der Komponente ausgerichtet ist, wobei die zweite Seitenfläche des quaderförmigen Kühlkörpers derart gewählt ist, dass die zweite Leiterplatte parallel zu einer Strömungsrichtung eines das Grundgehäuse durchströmenden Mediums angeordnet ist. Insbesondere Automatisierungsgeräte werden vorzugsweise mit ihrer Rückseite beispielsweise über eine Schnappvorrichtung auf eine Profilschiene aufgeschnappt, so dass diverse Automatisierungskomponenten nebeneinander auf der Profilschiene, z.B. in einem Schaltschrank oder an einer Wand aufgereiht werden können. Das zu kühlende Automatisierungsgerät ist dabei derart ausgerichtet, dass beispielsweise die Umgebungsluft als Kühlmittel aufgrund von Wärmekonvektion durch das Gehäuse zur Kühlung strömen kann. Da die zweite Leiterplatte parallel zu der Strömungsrichtung, beispielsweise der kühlenden Luft, ausgerichtet ist, kann die kühlende Luft optimal an der zweiten Leiterplatte und den Kühlrippen vorbeiströmen.

Um den besonders rauen Industriebedingungen, wie z.B. Vibrationen, Schock und Rüttelbelastungen von Automatisierungsgeräten gerecht zu werden, weist das Automatisierungsgerät in einer weiteren vorteilhaften Ausgestaltung eine Fronthaube auf, wobei die Fronthaube auf das Grundgehäuse aufsteckbar ist und zu einem geschlossenem Gehäuse zusammenfügbar ist, welches den Kühlkörper umgibt, die Fronthaube weist auf einer Innenseite der Fronthaube ein hervorstehendes Halteelement auf, wobei in einer weiteren zur Innenseite der Fronthaube gerichteten Seitenfläche des Kühlkörpers eine Ausnehmung angeordnet ist, in die das Halteelement bei geschlossenem Gehäuse eindringt, wobei zwischen dem hervorstehenden Halteelement und der Ausnehmung ein elastisches Formelement angeordnet ist, wobei das elastische Formelement ausgestaltet ist, Schwingungskräfte des Kühlkörpers in drei Raumachsen abzufangen. Dadurch, dass nun der Kühlkörper nicht mehr einzig und allein mit dem Festlager auf der Unterseite des Grundgehäuses befestigt ist, können Schwing- und Schockbeanspruchung besser abgefangen werden und das Automatisierungsgerät erfährt eine erhöhte Robustheit. Ein vorzeitiges Versagen durch überhöhte Schwing- und Schockbeanspruchungen, welche beispielsweise zu einem Gehäusebruch oder zu Beschädigungen der elektronischen Bauteile führen können, wird somit vermieden. Durch die Ausgestaltung von hervorstehenden Halteelementen in der Fronthaube, wobei die Halteelemente zusätzlich ein elastisches Formelement tragen und das Halteelement mit dem Formelement in den Ausnehmungen des Kühlkörpers eingesteckt ist, werden die Schwingungskräfte des Kühlkörpers in den drei Raumachsen abgefangen.

Das elastische Formelement ist dabei so ausgeführt, dass die Toleranzen ausgeglichen und damit die Schwingungskräfte in allen drei Raumachsen optimal abgefangen werden, hierzu ist es vorteilhaft, wenn die Befestigungsmittel so ausgestaltet sind, dass das Grundgehäuse auf einer Profilschiene befestigbar ist und die Fronthaube mit ihrem Halteelement so ausgestaltet ist, dass die Schwingungskräfte des Kühlkörpers auf die Fronthaube übertragen werden und die Fronthaube die Schwingungskräfte des Kühlkörpers auf das Grundgehäuse überträgt und das Grundgehäuse die Schwingungskräfte des Kühlkörpers auf die Profilschiene überträgt. Damit Grundgehäuse und Fronthaube zusammenhalten sind zwischen Grundgehäuse und Fronthaube mehrere Verrastvorrichtungen zum gegenseitigen Verrasten angeordnet.

Vorzugsweise ist das Halteelement als ein Befestigungsdom mit einer umlaufenden Nut und das elastische Formelement als ein O-Ring ausgestaltet, welcher in der Nut liegt. In der Fronthaube könnte beispielsweise ein stabiler Kunststoffdom ausgeprägt sein, auf welchem eine Nut für einen O-Ring eingeprägt ist. Dieser O-Ring stellt die Abstützung in allen drei Raumachsen sicher. Nach einer Montage der Fronthaube auf das Grundgehäuse findet sich dieser Dom mit dem O-Ring in einer kegelförmigen Aussparung im Kühlkörper wieder, wobei eine Anlage des O-Rings am Kühlkörper in allen drei Raumachsen immer sichergestellt ist.

Vorteilhafter Weise sind die Ausnehmungen kegelförmig ausgestaltet. Als weitere Vorteile für das Automatisierungsgerät mit Kühlkörper, bei welchem an einer ersten Seitenfläche des Kühlkörpers eine erste Flachbaugruppe mit einen zu kühlenden Bauteil und an einer zweiten Seitenfläche des Kühlkörpers eine zweite Flachbaugruppe mit einem zu kühlenden Bauteil angeordnet ist, sind zu nennen: Bei gleicher Baugröße des Automatisierungsgerätes kann mehr Verlustleistung abgeführt werden. Bei gleicher Verlustleistung könnte eine kleinere Baugröße realisiert werden. Einsparung von Material, wie z.B. Aluminium, da der Kühlkörper optimal dimensioniert werden kann. Einsparung von Kosten in der Produktion, wobei das Handling von zwei oder mehreren Kühlkörpern während der Montage im Gegensatz zu einem einzigen Kühlkörper verbessert ist. Auch ein Logistikaufwand in der Materialhaltung würde reduziert werden, zusätzliche Montagevorrichtungen und zusätzliche Werkzeugkosten könnten herabgesetzt werden. Die Gehäuseteile können einfacher gestaltet werden, da beispielsweise für die zweite Leiterplatte keine gesonderten Befestigungsmaßnahmen im Gehäuse notwendig sind.

Die Zeichnung zeigt ein Ausführungsbeispiel, wobei
- FIG 1: ein Automatisierungsgerät in einer dreidimensionalen Ansicht,
- FIG 2: das geöffnete Automatisierungsgerät mit Blick auf den Kühlkörper,
- FIG 3: das geöffnete Automatisierungsgerät ohne den Kühlkörper mit Blick auf die erste Leiterplatte und die zweite Leiterplatte,
- FIG 4: den Kühlkörper in einer dreidimensionalen Ansicht,
- FIG 5: den Kühlkörper aus FIG 4 in einer im Gegensatz zu FIG 4 gedrehten Darstellung,
- FIG 6: die Fronthaube,
- FIG 7: die Fronthaube mit Blickrichtung auf ihre Innenseite und
- FIG 8: einen Schnitt durch die Fronthaube, das Halteelement und den Kühlkörper an der Stelle der Ausnehmung.

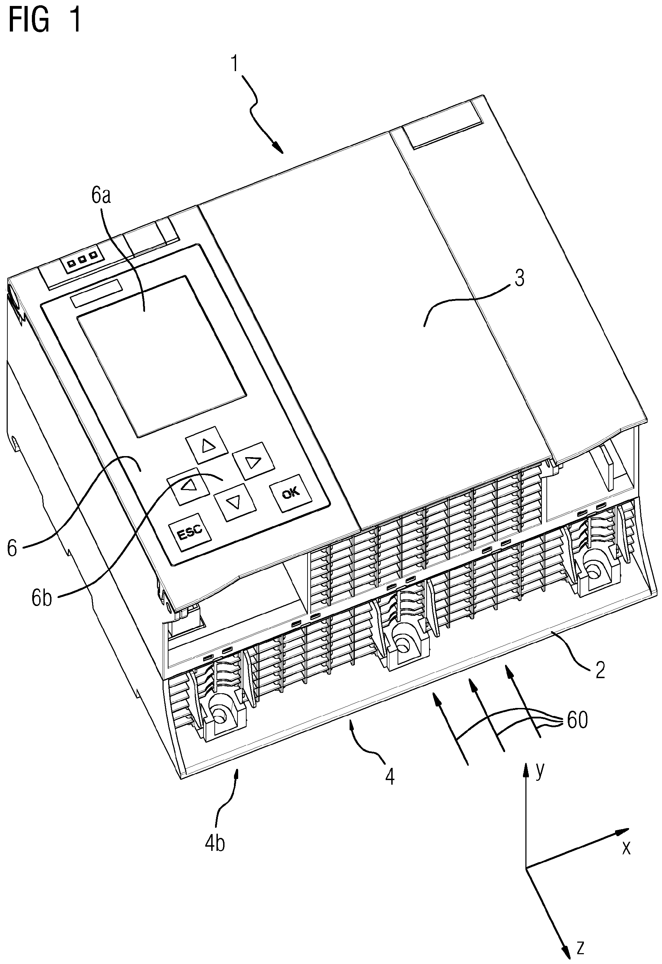

Gemäß FIG 1 ist ein Automatisierungsgerät 1 ausgestaltet für den Einsatz in einem Automatisierungsumfeld zur Automatisierung eines industriellen Prozesses abgebildet. Da Automatisierungsgeräte rauen Umgebungsbedingungen, wie Feuchtigkeit, Temperaturunterschiede, Vibrations- und Schockbelastung unterliegen, müssen diese Automatisierungsgeräte besonders robust ausgeführt sein. Das gezeigte Automatisierungsgerät 1 weist ein Grundgehäuse 2 und eine Fronthaube 3 auf, wobei zusätzlich eine Frontklappe 6 mit einem integrierten Display 6a und einem integrierten Bedienfeld 6b dargestellt sind.

Unterhalb des Automatisierungsgerätes 1 sind drei Raumachsen x,y,z dargestellt. Bei einer Schockbeanspruchung, Rüttelbeanspruchung oder Vibrationsbeanspruchung kann sich das Automatisierungsgerät 1 und insbesondere das Innenleben des Automatisierungsgerätes 1 in die drei Raumachsen x,y,z bewegen. In dieser perspektivischen Ansicht des Automatisierungsgerätes 1 aus FIG 1 fällt der Blick auf Lüftungsgitter welches es einem durchströmenden Medium, beispielsweise Luft, ermöglichen in einer Strömungsrichtung 60 durch das Grundgehäuse 2 zur Kühlung der Bauteile bzw. eines Kühlkörpers 20 zu strömen.

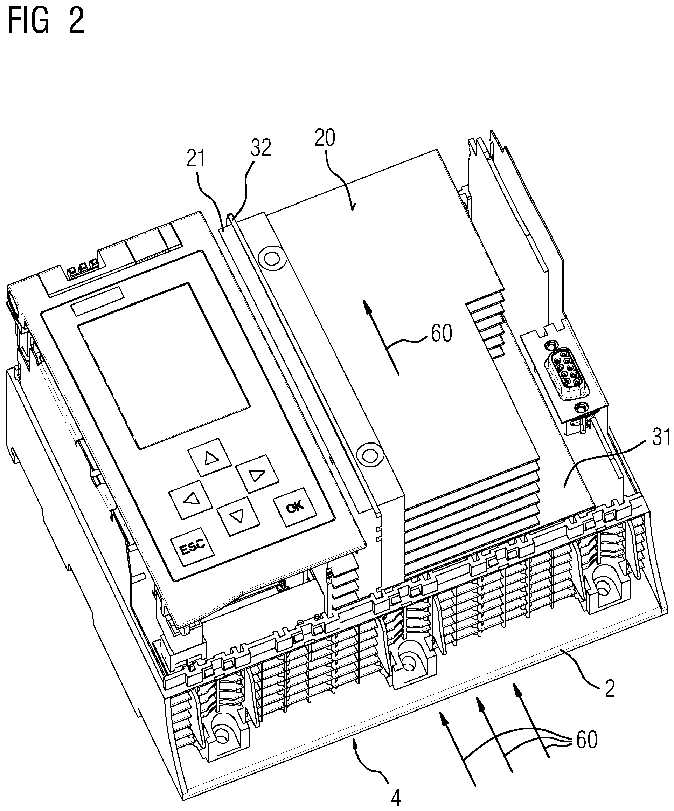

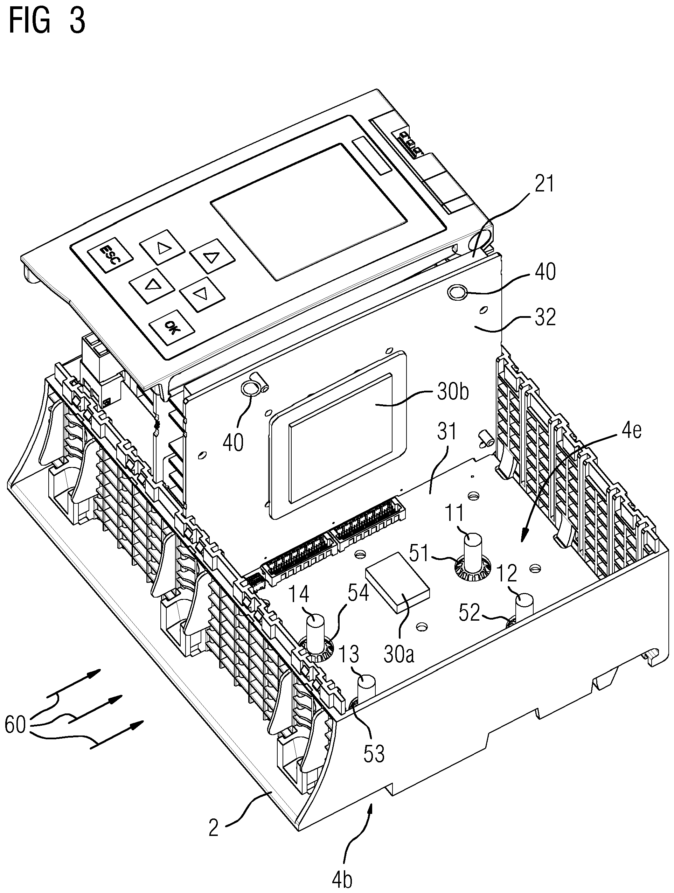

Die FIG 2 zeigt das aus FIG 1 bekannte Automatisierungsgerät 1 in einem geöffneten Zustand, wobei die Fronthaube 3 entfernt ist. Deutlich zu sehen ist nun der Kühlkörper 20, welcher auf einer ersten Leiterplatte 31 angeordnet ist. Die erste Leiterplatte 31 wiederum liegt auf einer Unterseite 4 des Grundgehäuses 2 (siehe auch FIG 3). Eine zweite Leiterplatte 32 steht im Wesentlichen senkrecht auf der ersten Leiterplatte 31.

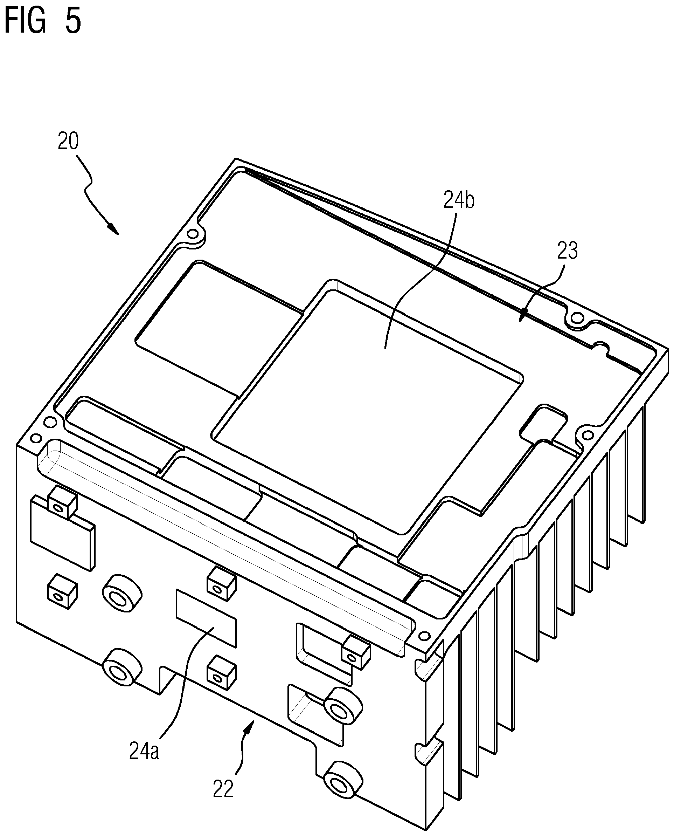

Wie in FIG 3 gezeigt weist die erste Leiterplatte 31 ein erstes elektronisches Bauteil 30a und die zweite Leiterplatte 32 ein zweites elektronisches Bauteil 30b auf. Der Kühlkörper 20 ist derart auf der ersten Leiterplatte 31 angeordnet, dass das erste elektronische Bauteil 30a zwischen der ersten Leiterplatte 31 und dem Kühlkörper 20 angeordnet ist. Der Kühlkörper 20 ist dabei quaderförmig ausgestaltet und liegt mit einer in einer ersten Seitenfläche 22 des Quaders eingearbeiteten ersten Kühlkontaktfläche 24a (siehe FIG 5) auf dem ersten elektronischen Bauteil 30a auf.

Da die zweite Leiterplatte 32 im Wesentlichen senkrecht zu der ersten Leiterplatte 31 angeordnet ist, kann das auf der zweiten Leiterplatte 32 angeordnete zweite elektronische Bauteil 30b in einer innerhalb einer zweiten Seitenfläche 23 des Kühlkörpers 20 eingearbeiteten zweiten Kühlkontaktfläche 24b mit dem Kühlkörper 20 kontaktieren.

Der Kühlkörper 20 ist mit seiner ersten Seitenfläche 22 mittels eines Festlagers 11,12,13,14 mit dem Grundgehäuse 2 verbunden. Die zweite Leiterplatte 32 ist an der zweiten Seitenfläche 23 des quaderförmigen Kühlkörpers 20 befestigt.

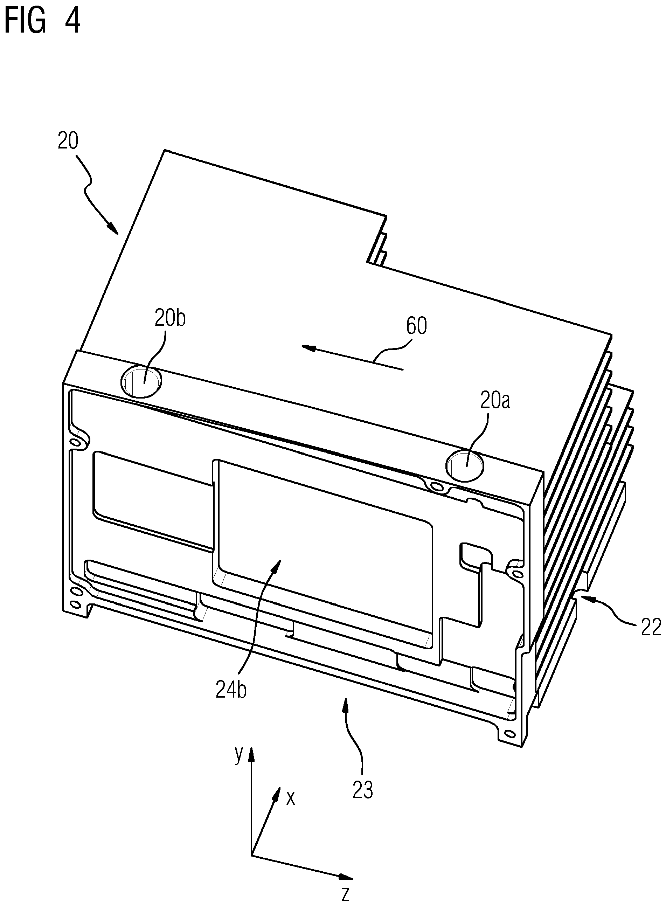

FIG 3 zeigt das Automatisierungsgerät 1 mit dem entfernten Kühlkörper 20. Dabei zeigt die zweite Leiterplatte 32, dass sie das zweite elektronische Bauteil 30b trägt. Die erste Leiterplatte 31 weist einen ersten Durchbruch 51, einen zweiten Durchbruch 52, einen dritten Durchbruch 53 und einen vierten Durchbruch 54 auf. Durch diese Durchbrüche 51,52,53, 54 ragt jeweils ein Schraubenbolzen hindurch. Die Verschraubungen des Kühlkörpers 20 mit den jeweiligen Schraubenbolzen bilden ein erstes Festlager 11, ein zweites Festlager 12, ein drittes Festlager 13 und ein viertes Festlager 14.
Gemäß FIG 4 ist der Kühlkörper 20 in einer Einzeldarstellung abgebildet. Der Blick fällt auf die zweite Seitenfläche 23 in welcher eine rechteckförmige Ausnehmung, welche die zweite Kühlkontaktfläche 24b bildet, zu erkennen ist. In dieser perspektivischen Ansicht des Kühlkörpers 20 steht der Kühlkörper 20 quasi auf der ersten Seitenfläche 22 auf. Gemäß FIG 5 ist der Kühlkörper 20 im Gegensatz zu der Darstellung in FIG 4 derart gedreht, dass nun der Blick auf die erste Seitenfläche 22 fällt. Die erste Seitenfläche 22 weist eine rechteckförmige erste Kühlkontaktfläche 24a für das erste elektronische Bauteil 30a auf.

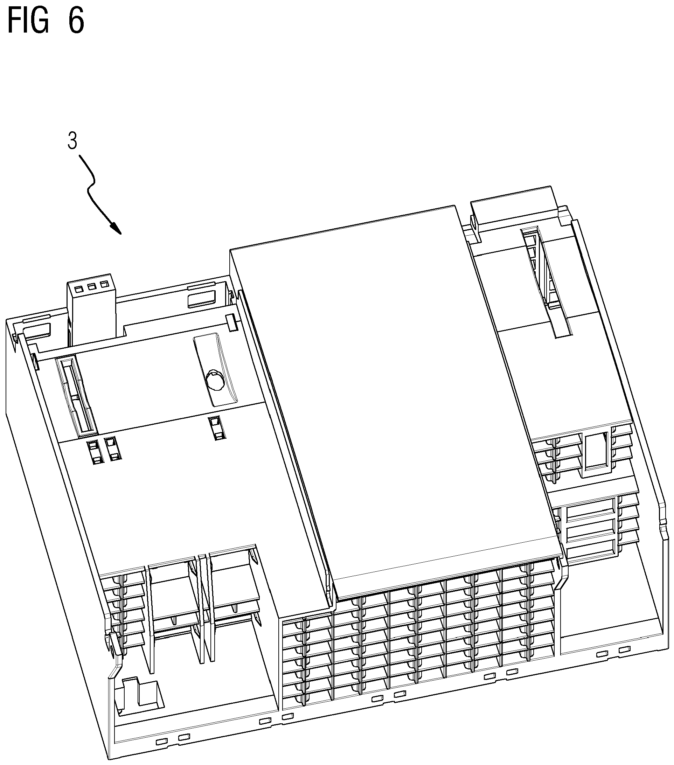

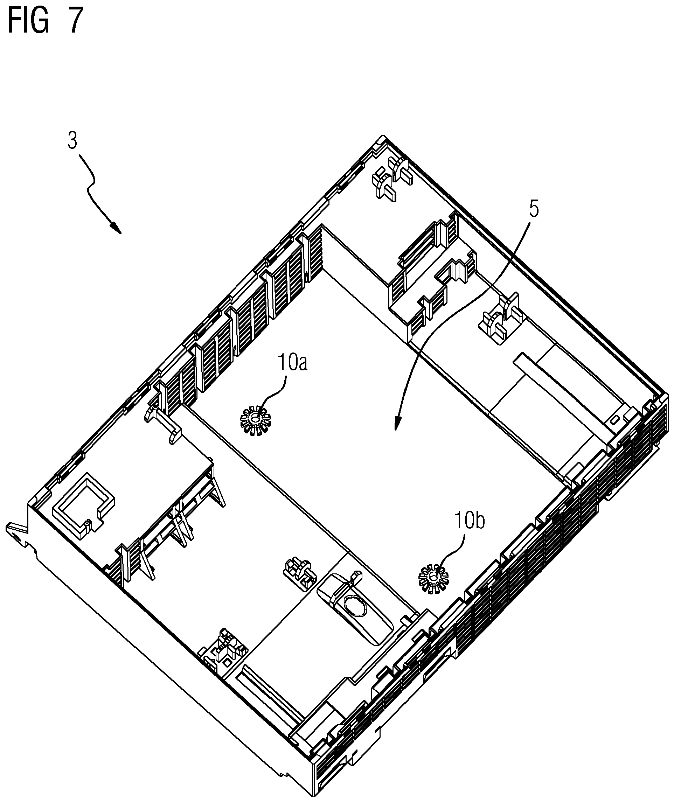

Mit der FIG 6 und FIG 7 ist die Fronthaube 3 dargestellt, wobei die FIG 6 die Fronthaube 3 in einer Draufsicht auf die Außenseite und die FIG 7 die Fronthaube 3 in einer Draufsicht auf die Innenseite zeigt. Dabei wird insbesondere mit FIG 7 das erste Halteelement 10a und das zweite Halteelement 10b gezeigt. Bei einem Aufsetzen der Fronthaube 3 auf das Grundgehäuse 2 greift das erste Halteelement 10a in die erste Ausnehmung 20a des Kühlkörpers 20 und das zweite Halteelement 10b greift in die zweite Ausnehmung 20b des Kühlkörpers 20. Der Kühlkörper 20 (siehe FIG 3) weist im Bereich einer Kante der zweiten Seitenfläche 23 die erste Ausnehmung 20a und die zweite Ausnehmung 20b auf.

Jeweils ein erster stabiler Kunststoffdom und ein zweiter stabiler Kunststoffdom, welche auf der Innenseite der Fronthaube 3 angebracht sind, können in die erste und die zweite Ausnehmung 20a,20b eingreifen. Um eine gute Abstützung in allen drei Raumachsen x,y,z zu erreichen, weist der Kunststoffdom jeweils eine Nut 41 für einen O-Ring auf.

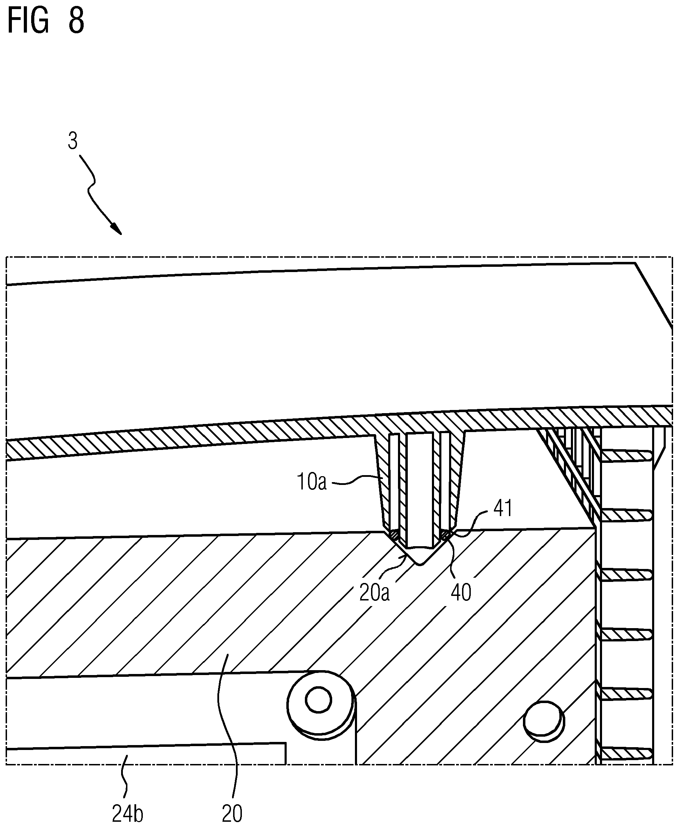

Die Anordnung des O-Ringes wird mit FIG 8, welche eine Schnittdarstellung zeigt, verdeutlicht. Der Kunststoffdom ist in FIG 8 als das erste Halteelement 10a dargestellt. Der Kunststoffdom weist eine umlaufende Nut 41 auf, in derer ein elastisches Formelement 40, nämlich der O-Ring, eingebracht ist. Andeutungsweise ist auf den Kühlkörper 20 die zweite Kühlkontaktfläche 24b für das zweite elektronische Bauteil 30b zu sehen.

Nach einer Montage der Fronthaube 3 auf das Grundgehäuse 2 befinden sich die Kunststoffdome mit O-Ring in der kegelförmigen Aussparung im Kühlkörper 20 wieder, wobei eine Anlage des O-Ringes am Kühlkörper 20 innerhalb dieser kegelförmigen Aussparung in allen drei Raumachsen x,y,z immer sichergestellt ist. Auf diese Weise wird ohne großen zusätzliche Befestigungsaufwand sichergestellt, dass in allen Richtungen, nämlich den drei Raumachsen x,y,z, die Entstehung großer Kräfte vermieden wird und das Automatisierungsgerät 1 somit mechanisch entlastet wird, welches dadurch sehr robust wird.

## Patentansprüche

1. Automatisierungsgerät (1) ausgestaltet für den Einsatz in einem Automatisierungsumfeld zur Automatisierung eines industriellen Prozesses, aufweisend
- eine erste Leiterplatte (31),
- eine zweite Leiterplatte (32),
- ein erstes zu kühlendes elektronisches Bauteil(30a) und
- ein zweites zu kühlendes elektronisches Bauteil(30b),
das erste elektronische Bauteil (30a) ist auf der ersten Leiterplatte (31) und das zweite zu kühlende Bauteil (30b) ist auf der zweiten Leiterplatte (32) angeordnet, wobei ein Kühlkörper (20) auf der ersten Leiterplatte (31) und das erste elektronische Bauteil (30a) zwischen der ersten Leiterplatte (31) und dem Kühlkörper (20) angeordnet ist,
der Kühlkörper (20) ist dabei quaderförmig ausgestaltet und liegt mit einer in einer ersten Seitenfläche (22) des Quaders eingearbeiteten ersten Kühlkontaktfläche (24a) auf dem ersten elektronischen Bauteil (30a) auf,
**dadurch gekennzeichnet, dass** die zweite Leiterplatte (32) im Wesentlichen senkrecht zu der ersten Leiterplatte (31) angeordnet ist, wobei eine in einer zweiten Seitenfläche (23) des Kühlkörpers (20) eingearbeitete zweite Kühlkontaktfläche (24b) auf dem zweiten elektronischen Bauteil (30b) aufliegt.

2. Automatisierungsgerät (1) nach Anspruch 1, wobei die zweite Leiterplatte (32) an der zweiten Seitenfläche (23) des Kühlkörpers (20) befestigt ist.

3. Automatisierungsgerät (1) nach Anspruch 2, aufweisend
- ein Grundgehäuse (2),
wobei der Kühlkörper (20) mit seiner ersten Seitenfläche (22) mittels eines Festlagers (11,12,13,14) mit dem Grundgehäuse (2) verbunden ist, wobei zwischen einer Innenseite (4a) einer Unterseite (4) des Grundgehäuses (2) und der ersten Seitenfläche (22) des Kühlkörpers (20) die erste Leiterplatte (31) angeordnet ist, weiterhin ist eine Außenseite (4b) der Unterseite (4) des Grundgehäuses (2) mit Befestigungsmitteln für eine Montage an einer vertikalen Komponente ausgestaltet, wobei im montierten Zustand des Grundgehäuses (2) die Unterseite (4) parallel zu der Komponente ausgerichtet ist, wobei die zweite Seitenfläche (23) des Kühlkörpers (20) derart gewählt ist, dass die zweite Leiterplatte (32) parallel zu einer Strömungsrichtung (60) eines das Grundgehäuse (2) durchströmenden Mediums angeordnet ist.

4. Automatisierungsgerät (1) nach einem der Ansprüche 1 bis 3, mit einer Fronthaube (3),
wobei die Fronthaube (3) auf das Grundgehäuse (2) aufsteckbar ist und zu einem geschlossenen Gehäuse zusammenfügbar ist, welches den Kühlkörper (20) umgibt, die Fronthaube (3) weist auf einer Innenseite (5) der Fronthaube (3) ein hervorstehendes Halteelement (10a,10b) auf, wobei in einer weiteren zur Innenseite (5) der Fronthaube (3) gerichteten Seitenfläche des Kühlkörpers (20) eine Ausnehmung (20a,20b) angeordnet ist, in die das Halteelement (10a,10b) bei geschlossenem Gehäuse eindringt, wobei zwischen dem hervorstehenden Halteelement (10a,10b) und der Ausnehmung (20a,20b) ein elastisches Formelement (40) angeordnet ist, wobei das elastische Formelement (40) ausgestaltet ist Schwingungskräfte des Kühlkörpers (20) in drei Raumachsen (x,y,z) abzufangen.

5. Automatisierungsgerät (1) nach einem der Ansprüche 3 bis 4, wobei die Befestigungsmittel so ausgestaltet sind, dass das Grundgehäuse (2) auf einer Profilschiene befestigbar ist und die Fronthaube (3) mit ihrem Halteelement (10a,10b) so ausgestaltet ist, dass die Schwingungskräfte des Kühlkörpers (20) auf die Fronthaube (3) übertragen werden und die Fronthaube (3) die Schwingungskräfte des Kühlkörpers (20) auf das Grundgehäuse (2) überträgt und das Grundgehäuse (2) die Schwingungskräfte des Kühlkörpers (20) auf die Profilschiene überträgt.

6. Automatisierungsgerät (1) nach Anspruch 4 oder 5, wobei das Halteelement (10a,10b) als ein Befestigungsdom mit einer umlaufenden Nut (41) und das elastische Formelement (40) als ein O-Ring ausgestaltet ist, welcher in der Nut (41) liegt.

7. Automatisierungsgerät (1) nach einem der Ansprüche 4 bis 6, wobei die Ausnehmung (20a,20b) kegelförmig ausgestaltet ist.

## Claims

1. Automation device (1) embodied for use in an automation environment for the purpose of automating an industrial process, comprising
- a first printed circuit board (31),
- a second printed circuit board (32),
- a first electronic component (30a) requiring to be cooled and
- a second electronic component (30b) requiring to be cooled, the first electronic component (30a) is arranged on the first printed circuit board (31) and the second component (30b) requiring to be cooled is arranged on the second printed circuit board (32), wherein a heatsink (20) is arranged on the first printed circuit board (31) and the first electronic component (30a) is arranged between the first printed circuit board (31) and the heatsink (20),
the heatsink (20) is in this case embodied in the shape of a cuboid and rests on the first electronic component (30a) with a first cooling contact surface (24a) incorporated in a first lateral surface (22) of the cuboid,
**characterised in that**
the second printed circuit board (32) is arranged essentially vertically with respect to the first printed circuit board (31), wherein a second cooling contact surface (24b) incorporated in a second lateral surface (23) of the heatsink (20) rests on the second electronic component (30b).

2. Automation device (1) according to claim 1, wherein the second printed circuit board (32) is secured to the second lateral surface (23) of the heatsink (20).

3. Automation device (1) according to claim 2, comprising
- a basic housing (2),
wherein the heatsink (20) is connected by its first lateral surface (22) to the basic housing (2) by means of a locating bearing (11,12,13,14), wherein the first printed circuit board (31) is arranged between an inside face (4a) of a bottom side (4) of the basic housing (2) and the first lateral surface (22) of the heatsink (20); in addition, an outside face (4b) of the bottom side (4) of the basic housing (2) is embodied with fastening means for allowing mounting to a vertical component, wherein in the assembled state of the basic housing (2) the bottom side (4) is aligned in parallel with the component, wherein the second lateral surface (23) of the heatsink (20) is chosen such that the second printed circuit board (32) is arranged parallel to a flow direction (60) of a medium flowing through the basic housing (2).

4. Automation device (1) according to one of claims 1 to 3, having a front hood (3),
wherein the front hood (3) can be slotted onto the basic housing (2) and assembled to form a closed housing which encloses the heatsink (20), the front hood (3) has, on an inside face (5) of the front hood (3), a projecting retaining element (10a,10b), wherein a recess (20a,20b) is arranged in a further lateral surface of the heatsink (20) directed toward the inside face (5) of the front hood (3), into which recess the retaining element (10a,10b) engages when the housing is closed, wherein an elastic shaped element (40) is arranged between the projecting retaining element (10a,10b) and the recess (20a,20b), wherein the elastic shaped element (40) is embodied to absorb oscillating forces of the heatsink (20) in three spatial axes.

5. Automation device (1) according to one of claims 3 to 4, wherein the fastening means are embodied such that the basic housing (2) can be mounted on a profile rail and the front hood (3) together with its retaining element (10a,10b) is embodied in such a way that the oscillating forces of the heatsink (20) are transmitted onto the front hood (3) and the front hood (3) transmits the oscillating forces of the heatsink (20) onto the basic housing (2) and the basic housing (2) transmits the oscillating forces of the heatsink (20) onto the profile rail.

6. Automation device (1) according to claim 4 or 5, wherein the retaining element (10a,10b) is embodied as a securing dome with a circumferential groove (41) and the elastic shaped element (40) as an O-ring which lies in the groove (41).

7. Automation device (1) according to one of claims 4 to 6, wherein the recess (20a,20b) is embodied as cone-shaped.

## Revendications

1. Appareil ( 1 ) d'automatisation conformé pour être utilisé dans un environnement d'automatisation, pour l'automatisation d'un processus industriel, comprenant
- une première plaquette ( 31 ) à circuit imprimé,
- une deuxième plaquette ( 32 ) à circuit imprimé,
- un premier composant ( 30a ) électronique à refroidir et
- un deuxième composant ( 30b ) électronique à refroidir,
le premier composant ( 30a ) électronique est disposé sur la première plaquette ( 31 ) à circuit imprimé et le deuxième composant ( 30b ) à refroidir est disposé sur la deuxième plaquette ( 32 ) à circuit imprimé, un refroidisseur ( 20 ) étant mis sur la première plaquette ( 31 ) à circuit imprimé et le premier composant ( 30a ) électronique étant mis entre la première plaquette ( 31 ) à circuit imprimé et le refroidisseur ( 20 ),
le refroidisseur ( 20 ) est conformé en parallélépipède et s'applique au premier composant ( ( 30a ) électronique par une première surface ( 24a ) de contact de refroidissement usinée dans une première surface ( 22 ) latérale du parallélépipède, **caractérisé en ce que**
la deuxième plaquette ( 32 ) à circuit imprimé est disposée sensiblement perpendiculairement à la première plaquette ( 31 ) à circuit imprimé, une deuxième surface ( 24b ) de contact de refroidissement, usinée dans une deuxième surface ( 23 ) latérale du refroidisseur ( 20 ), étant appliquée au deuxième composant ( 30b ) électronique.

2. Appareil ( 1 ) d'automatisation suivant la revendication 1, dans lequel la deuxième plaquette ( 32 ) à circuit imprimé est fixée à la deuxième surface ( 23 ) latérale du refroidisseur ( 20 ).

3. Appareil ( 1 ) d'automatisation suivant la revendication 2, comprenant
- un boîtier ( 2 ) de base,
le refroidisseur ( 20 ) étant relié au boîtier ( 2 ) de base par sa première surface ( 22 ) latérale, au moyen d'un palier ( 11, 12, 13, 14 ) fixe, la première plaquette ( 31 ) à circuit imprimé étant disposé entre une face ( 4a ) intérieure d'un côté ( 4 ) inférieur du boîtier ( 2 ) de base et la première surface ( 22 ) latérale du refroidisseur ( 20 ), en outre, la face ( 4b ) extérieure du côté ( 4 ) inférieur du boîtier ( 2 ) de base étant conformée en ayant des moyens de fixation pour un montage sur un composant vertical, dans lequel, lorsque le boîtier ( 2 ) de base est à l'état monté, le côté ( 4 ) inférieur est dirigé parallèlement au composant, la deuxième surface ( 23 ) latérale du refroidisseur ( 20 ) étant choisie, de manière à ce que la deuxième plaquette ( 32 ) à circuit imprimé soit parallèle à une direction ( 60 ) d'écoulement d'un fluide passant dans le boîtier ( 2 ) de base.

4. Appareil ( 1 ) d'automatisation suivant l'une des revendications 1 à 3, ayant une coiffe ( 3 ) avant,
dans lequel la coiffe ( 3 ) avant peut être enfilée sur le boîtier ( 2 ) de base et peut être assemblée en un boîtier fermé, qui entoure le refroidisseur ( 20 ), la coiffe ( 3 ) avant a, sur un côté ( 5 ) intérieur de la coiffe ( 3 ) avant, un élément ( 10a, 10b ) de maintien en saillie, dans lequel, dans une autre surface latérale, dirigée vers le côté ( 5 ) intérieur de la coiffe ( 3 ) avant, du refroidisseur ( 20 ), est disposé un évidemment ( 20a, 20b ) dans lequel l'élément ( 10a, 10b ) de maintien pénètre lorsque le boîtier est fermé, dans lequel un élément ( 40 ) élastique de forme est disposé entre l'élément ( 10a, 10b ) de maintien en saillie et l'évidemment ( 20a, 20b ), l'élément ( 40 ) élastique de forme étant conformé pour absorber les forces de vibration du refroidisseur ( 20 ) dans trois axes ( x, y, z ) de l'espace.

5. Appareil ( 1 ) d'automatisation suivant l'une des revendications 3 à 4, dans lequel les moyens de fixation sont conformés de manière à pouvoir fixer le boîtier ( 2 ) de base sur un rail profilé et la coiffe ( 3 ) avant est conformée, par son élément ( 10a, 10b ) de maintien, de manière à transmettre les forces de vibration du refroidisseur ( 20 ) à la coiffe ( 3 ) avant et à ce que la coiffe ( 3 ) avant transmette les forces de vibration du refroidisseur ( 20 ) au boîtier ( 2 ) de base et de manière à ce que le boîtier ( 2 ) de base transmette les forces de vibration du refroidisseur ( 20 ) au rail profilé.

6. Appareil ( 1 ) d'automatisation suivant la revendication 4 ou 5, dans lequel l'élément ( 10a, 10b ) de maintien est conformé, sous la forme d'un dôme de fixation ayant une rainure ( 41 ) faisant le tour et l'élément ( 40 ) élastique de forme, sous la forme d'un joint torique, qui se trouve dans la rainure ( 41 ).

7. Appareil ( 1 ) d'automatisation suivant l'une des revendications 4 à 6, dans lequel l'évidemment ( 20a, 20b ) est conformé en forme de cône.
